# EUROPEAN PATENT SPECIFICATION

(11) **EP 2 688 093 B1**
(45) Date of publication and mention of the grant of the patent: **18.07.2018**
(21) Application number: 12177060.6
(22) Date of filing: 19.07.2012
(51) Int. Cl.: H01L 21/98, H01L 21/60, H01L 21/677, H01L 23/488, B23K 1/00, B23K 1/20, B23K 35/02, B23K 35/24, B23K 35/26

(54) **Method of and apparatus for fluidic self-assembly of components on a substrate**
Verfahren und Vorrichtung zur Selbstmontage mittels eines Fluids von Komponenten auf einem Substrat
Procédé et appareil permettant l'auto-assemblage à l'aide d'un fluide de composants sur un substrat

(43) Date of publication of application: 22.01.2014
(60) Divisional application: 14176541.2
(73) Proprietor: Technische Universität Ilmenau, 98693 Ilmenau (DE)
(72) Inventor: Jacobs, Heiko O., 98693 Ilmenau (DE)
(74) Representative: Patentanwälte Geyer, Fehners & Partner mbB

(56) References cited:
- EP-A1- 2 009 971
- EP-A2- 0 747 948
- US-A1- 2003 215 981
- US-A1- 2005 003 570
- US-A1- 2008 023 435
- US-A1- 2008 032 425
- US-A1- 2010 096 439
- US-A1- 2011 277 917
- US-B1- 6 527 964
- US-B1- 7 080 444
- US-B2- 7 774 929
- CHIA-SHOU CHANG ET AL: "Self-Assembly of Microchips on Substrates", ELECTRONIC COMPONENTS AND TECHNOLOGY CONFERENCE 2006, 56TH SAN DIEGO, CA MAY 30 - JUNE 2, 2006, PISCATAWAY, NJ, USA,IEEE, 30 May 2006 (2006-05-30), pages 1533-1538, XP010923588, DOI: 10.1109/ECTC.2006.1645859 ISBN: 978-1-4244-0152-9

## Description

### Field of the Invention

The invention relates to a method of self-assembly including self-alignment of components on a substrate on the basis of surface tension of liquid solder for applications that require reliable operation of the self-assembled objects at elevated operation temperatures. It also relates to a method and an apparatus of fluidic self-assembly of a plurality of components onto receptor sites on the surface of a substrate, where each receptor site is formed of a selective adhesive which adheres to at least a part of the components resulting in the capture, self-alignment and/or attachment of the components at the receptor sites, integrating component delivery, removal, and attachment over increasingly large surfaces.

### Description of Prior Art

The construction of almost all man-made artifacts such as packaged LEDs, solid state lighting panels, cell phones, or computers relies on robotic assembly lines that place, package, and interconnect a variety of devices that have microscopic dimensions, i.e. with dimensions smaller than 1 mm. The key to the realization of these devices and systems is our ability to integrate/assemble components as well as to link/interconnect the components to transport energy and information. The tools of choice in the established manufacturing industry are robotic pick and place machines and wire bonding concepts. Conventional robotic methods, however, are challenged because of the difficulty in building machines that can economically manipulate and interconnect microscopic parts over large areas with high throughput. At the other extreme, nature forms materials, structures, and living systems by self-assembly on a molecular length scale. As a result self-assembly based fabrication strategies are widely recognized as inevitable tools in nanotechnology. However, self-assembly is not limited to the nanometer length scale. Strategies based on self-assembly are projected to have a major impact in the future manufacturing of macroscopic systems - with dimensions larger than 1 mm - that use microscopic building blocks.

In US 5,545921 and US 6,780,696 a process is described to direct the assembly of small radio frequency identification (RFID) tags. Semiconductor chips are suspended in a liquid flow over a surface containing correspondingly shaped wells that act as receptors for the device components. The device components settle into these wells due to gravitational forces.

The process has the advantage that it produces a flat surface. Assembled components fill the wells and form a flush surface. Subsequent components slide over already assembled objects and there is little interference. This particular process has the advantage the self-assembled objects are not protruding. Scaling to large areas and continuous assembly on webs having widths of more than 10 cm has been possible with little effort in terms of the machine design. This process requires very specific die geometries - L or T shaped blocks for angular orientation and trapezoids to prevent up-side down assembly - these particular shapes are not common in the microelectronics industry; most dies are square in shape. While they remain valid solutions they limit wide spread use. Attempts of adoption by other manufacturers remain critically low because of the required use of trapezoidal chips that are not widely used. A more universal solution is desired and would increase the chance of technology adoption and transition.

An advantage of all self-assembly processes is that they are massively parallel, which potentially reduces the assembly costs dramatically relative to the costs of traditional deterministic pick and place methods that use serial robotic methods.

In the publication *"*Self-assembly at all scales" from Whitesides et al., published in Science 295, p. 2418-2421 (2002), the use of surface tension to self-assemble components that are freely suspended in a liquid was described. In the publication *"*Self-assembly of mesoscale objects into ordered two-dimensional arrays" of Bowden et al., published in Science 276, p. 322-325 (1997), the self-assembly of components having a size of 5 mm with patterned hydrophobic surfaces into ordered aggregates has been described.

The concept of solder directed self-assembly is for example described and applied in US 7,774,929. The components self-assemble and attach to the solder-coated areas due to the reduction of the surface free energy of the liquid solder surface. The method has been applied to direct the assembly of chip-sized components onto surfaces from a heated suspension primarily in the context of solid state lighting, photovoltaic, and multicomponent sensors. One of the mechanisms of self-assembly and attachment of the chips is based on surface tension directed self-assembly on the basis of liquid solder. The self-assembly process is driven by the minimization of surface free energy of the liquid solder. A difference here when compared to the prior art on surface tension directed self-assembly at the time was that the solder was placed only on the receiving substrate to form a selective adhesive element for metal contacts on conventional semiconductor chips. The randomly moving self-assembly semiconductor chips themselves did not have a solder bump on their surface. In the particular design, the metal contact on the component binds to the liquid-solder-based-receptors during the self-assembly process at a temperature where the solder is molten. The solder wets the metal contact during the process and the minimization of the free surface area of the liquid solder drives the assembly into a stable, aligned position. The parallel assembly of large number of components has been accomplished using this process. The liquid-solder-coated areas act as receptors for subunits during the assembly - no manipulator is needed -, they form rigid bonds upon solidification - no adhesive is needed -, and provide electrical input/output-connectors to operate the final device - no wire bonder is needed.

Solder directed fluidic self-assembly as it has been described today is done inside a closed vial, barrel, or container to suspend the self-assembly components in a fluid at a temperature where the solder is molten.

A major limitation of solder directed self-assembly as it is known today is the fact that the melting point of the solder has to be below the boiling point of the fluid that is used in the fluidic self-assembly process. For example often water is used as a fluid which limits the melting point of the solder to be below 100°C. To assemble devices then mostly solder is used that has a melting point below 60°C. While it is possible to replace the water with ethylene glycol or other higher boiling point liquids, it has not yet been possible to form reliable interconnects using this approach. It appears that there are no solvents that support the self-assembly at sufficiently high temperatures that would work with the same solder based interconnects that are used in the electronics industry. This is the main reason why solder directed self-assembly has not been used in an industrial process today.

On the other hand, in the more established field of deterministic robotic flip chip assembly and packaging of semiconductor components sometimes a solder stack is used that is composed of two solder layers that have different compositions and thus different melting points. In this field the objects are always brought into contact using micromanipulators, referred to as deterministic rather than stochastic assembly.

In TW 517370 B for example the stack is used to avoid bridging between pads and to increase the bump height as well as to better control the bump dimensions.

Another example is described in US 5,872,400. There, solder balls are disclosed that have high melting point cores which are partially or completely coated with a lower melting point solder. The balls are applied in a ball grid array (BGA) and the particular process allows for a tighter control of the ball dimensions which in turn allows for higher interconnect density in surface mount packaging without bridging.

Another example is described in US 6,340,630. Again the layered system is used in the application field of BGA. The application describes transfer of solder bumps from a mold leading to BGA connection on a wafer that have a dual metallurgical composition after reflow.

Another example is described in WO 96/16442. The two layer solder bump is used in flip chip assembly as an interconnect material.

Another problem is that self-assembled chips and objects are not generally flush with the surrounding surface. To get a flush surface it is required to use particular die shapes such as trapezoidal shaped dies as in US 5,545,291 which are not very common in the industry. A more common die shape is based on rectangular square shaped blocks. These can be self-assembled onto receptors using selective adhesive elements of which liquid solder is the element of choice since it likes to wet certain metals which results into the capture of chips with metal contacts. From an application point of view this is an advantage since it is less restrictive on the components and shapes that can be assembled. However, scaling to large areas is more challenging since protruding objects interfere with the component delivery mechanism which has been done using a slurry of self-assembly components that slides along the surface to populate receptor sides.

Examples of prior implementations are described in US 5,545,291 and US 7,774,929. The first document describes the use of a slurry of components that slides across a planar surface. The components drop into the recessed openings on the basis of gravity and shape recognition. The second document describes the use of a closed rotating barrel that holds the self-assembly substrate. The substrate is attached inside the barrel and points towards the center of the barrel. The barrel itself holds the self-assembly objects. Back-and-forth partial rotation of the barrel leads to a successive sweeping motion of self-assembly components that slide over the surface and that interact with the receptors. Both solutions work perfectly well using trapezoidal shaped dies, the process described in US 7,774,929 is also applied to semiconductor chips and shapes that include rectangular blocks which are more common in industry. However, both solutions have in common that they cause shear forces in cases of self-assembled objects that are not flush with the surrounding surface. The collective movement of excess self-assembly components causes a shear force on already assembled objects which becomes increasingly difficult to manage if a large number of excess components is present in the system. Self-assembled objects are often raised features which are not flush with the intermediate surrounding surface. The shear force becomes increasingly difficult to manage if large volumes of excess components slide across the surface which is required in cases where the substrate size is increased. Large area assembly of objects that are raised above the receiving surface has not been possible using a simple system like the barrel design. Published results regarding the substrate size have been smaller than 2 cm² in cases where the objects were raised features.

US 2008/023435 A1 describes a method for self-assembling a plurality of microstructures onto a substrate comprising using a bonding material to make the microstructures assembled onto the substrate by a physical attraction force. Microstructures are formed on a transparent intermediate substrate and the substrate is arranged up-side-down with its front side immersed in container with a liquid medium. The microstructures are released from the transparent substrate using a laser beam and fall due to gravity into the liquid medium in which they self-assemble to another substrate located at the bottom of the container. Erroneously assembled microstructures are less strongly bonded and removed by using a vibration mechanism.

US 2005/003570 A1 describes a method for mounting semiconductor elements onto a substrate by using a fluidic self-assembly technique during fabrication. A liquid containing the semiconductor elements is poured over a substrate in which recessed portions have been formed to receive the semiconductor elements. After pouring has stopped, the plane substrate is rotated within that plane to remove improper oriented semiconductor elements. The plane of the substrate is inclined with respect to the horizontal plane to facilitate removal when rotating.

Another method for disposing microstructures on recesses in a substrate by using a liquid is described in US 2011/277917 A1. Several measures are taken to increase the probability that the microstructures are placed correctly, including hydrophilic and hydrophobic preparation of different surfaces on the microstructures and recesses, with the substrate being immersed into an electrolyte solution to which a voltage is applied.

### Description of the Invention

Object of the invention is to enhance a method of and to develop an apparatus for self-assembly of a plurality of components onto receptor sites on a surface of a substrate where the receptor sites are formed of selective adhesives and in particular to reduce shear forces caused by protruding elements to a minimum to allow the assembly of larger numbers of protruding components than currently possible. In combination, self-assembly of large numbers of protruding components over wide areas substrates forming reliable interconnects should be achieved.

The problem is solved by a method as described in claim 1 and an apparatus as described in claim 7. Preferred and advantageous embodiments of the method and the apparatus are described in the dependent claims.

It is understood that the features mentioned before and the features to be explained below are applicable not only in the combination stated but also in other combinations without leaving the scope of the present invention as long as said combinations of features are covered by the appended claims.

### Brief Description of the Drawings

Below, the invention will be explained in more detail with reference to the accompanying drawings figures 6-13, which also show features essential to the invention, among others, and in which
- Fig. 1: shows the principle of a self-assembly method using a solder stack,
- Fig. 2: shows an implementation using a conveyor belt,
- Fig. 3: shows another implementation of the method using pedestals,
- Fig. 4: shows the implementation of Fig. 3 using a conveyer belt.
- Fig. 5: shows shear forces occurring in prior art apparatus,
- Fig. 6: shows a first example for an apparatus for self assembly
- Fig. 7: shows a second example for an apparatus for self-assembly using a conveyor belt
- Fig. 8: shows a third example of an apparatus for self-assembly with two units successively coupled,
- Fig. 9: shows a fourth example of an apparatus for self-assembly based on a web,
- Fig. 10 a, b): shows examples for collecting means for components to be reused,
- Fig. 11: shows an example for arranging pathways where the excess components are transported,
- Fig. 12 a, b): shows two ways for pumping excess components to be reused, and
- Fig. 13: shows a combination of a collection point array equipped with jet pumps.

### Detailed Description of the Drawings

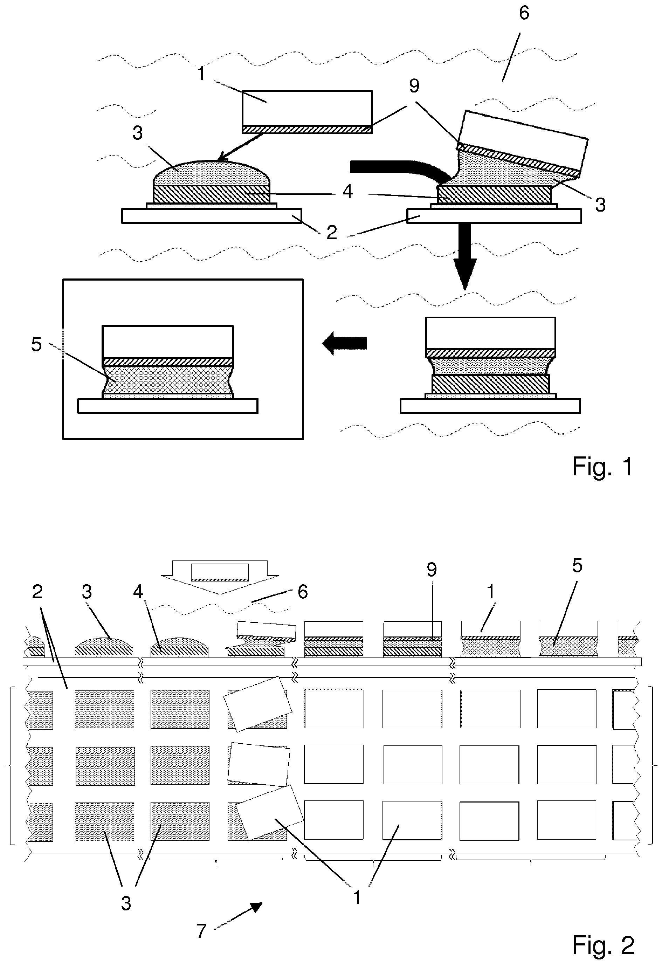

Figure 1 shows the basic concept of a method of self-assembly including self-alignment of components 1 on a substrate 2 on the basis of surface tension of liquid solder. The method involves a solder stack composed of an outermost layer of solder 3 on top and at least another layer of solder 4, the layers of solder having successively increasing melting points from top to bottom.

The method comprises the following steps: In a first step the solder stack is heated to a temperature between the melting point of the outermost layer of solder 3 and the at least another layer of solder 4. This corresponds to the situation shown in figure 1 in the upper left corner. The outermost layer 3 is molten; due to the surface tension the molten solder has a convex shape on its surface towards its environment since it tries to minimize its surface free energy. The molten outermost layer 3 is then used to form a receptor which adheres to the components 1 as shown in the upper right corner of figure 1. Since the molten solder tends to minimize its surface, when a component 1 is adhered to the solder, this will result in the self-assembly, self-alignment and attachment of the components 1. This situation is shown in the lower right corner of figure 1. The outermost layer of solder 3 is still molten. In the next step the solder stack is heated to a temperature above the melting point of the at least another layer of solder 4. This initialises a reflow soldering-process of the outermost and the at least another layer of solder 3, 4 to form a mixed solder layer as an alloy 5 to form an interconnect between the components and the substrate with a melting point higher than that of the outermost layer of solder 3. This situation is shown in the lower left corner of figure 1.

Melting of solder is achieved in a liquid environment, the liquid being heated but having a boiling point well above the melting point of the solder used in the outermost layer 3. In an advantageous embodiment the components 1 therefore are dispensed in a first fluid 6 which is also shown in the first three steps displayed in figure 1. The first fluid 6 is being heated to a temperature below its boiling point but above the melting point of the outermost layer of solder 3. This layer of solder 3 then forms a selective adhesive to capture the components 1 as shown in the upper right corner of figure 1.

To heat the at least another layer of solder 4 to a temperature above its melting point this environment has to be changed which is why the last step of the method displayed in the lower left corner of figure 1 is shown in a box. This step can for example be performed in a second fluid at a temperature above the boiling point of the first fluid, or in a gaseous environment like nitrogen or argon, as shown in figure 1.

This method overcomes the problem of prior solder directed self-assembly processes that used a single solder layer leading to an interconnect that had a melting point that was limited to be smaller than the boiling point of the first fluid 6 and where no reliable interconnects could be made which would withstand the higher operating temperatures of the assembled devices as they often occur in microdevices. It describes a two-face solder-based receptor to enable high temperature operation of self-assembled objects. However, this aspect is limited to the field of surface tension directed self-assembly on the basis of liquid solder. It extends the allowed operating temperature of current assemblies produced using prior art in the field of solder directed self-assembly which is somewhere in the range of 40-100°C to well above 200°C. The new kind of solder based receptor is composed of at least two different solder layers. The outermost layer of solder 3 is composed of a low melting point metal alloy and the at least another layer of solder 4 is composed of a higher melting point metal alloy. Using this new type of receptor the self-assembly process is divided into the aforementioned two-step sequence. The first step is carried out at low temperature where the low melting point section of the receptor is molten. Examples for low melting point alloys are various combinations of the element In, Bi, Sn, Zn, Cd, and Pb in different combination and ratios. To fulfil the *Restriction of Hazardous Substances Directive* (RoHS), lead and cadmium free solder alloys are also available. Different melting points of the solder can be realised using different alloys, for instance a melting point (MP) of 29.8° using 100% Ga, a MP of 47°C using an alloy of {44.7%Bi, 22.6% Pb, 19.1% In, 8.3% Sn, 5.3 % Cd}, a MP of 58°C using {49% Bi, 18% Pb, 12% Sn, 21% In}, a MP of 60°C using {51% In 32.5% Bi 16.5% Sn}, a MP of 69°C using {49% Bi, 18% Pb, 18% In, 15% Sn}, a MP of 79°C using {57% Bi, 26% In, 17% Sn}, a MP of 72 °C using {66.3% In, 33.7% Bi}, a MP of 79°C using {57% Bi, 26% In, 17% Sn}, a MP of 95°C using {52.5% Bi, 32% Pb, 15.5% Sn}, a MP of 103 °C using {54% Bi, 26% Sn, 20% Cd}, a MP of 108°C using { 52.2% In, 46% Sn, 1.8% Zn}, a MP of 118°C using {58% Sn, 42% In} or {50% Sn, 50% In}, a MP of 138°C using {57% Bi, 43% Sn}.These metal alloys work well due to high surface tension and fast wetting characteristic attaching to the metal contacts of the components 1. The first self-assembly step can and should therefore still be performed in a liquid environment at a modest temperature. For example, the first fluid 6 can be water, ethylene glycol or oil.

The second self-assembly step is a higher temperature reflow step which can be performed in a liquid having a higher boiling point than the first fluid, for example various oil, or inorganic and organic solvents can be used. It also can be performed in a gaseous environment like in air, nitrogen or argon. The temperature is raised to reflow both layers. The reflow step completes the self-assembly and final self-alignment while producing a reliable interconnect with increased melting point. The higher melting point solder layer can therefore be composed of a large variety of metallic alloys commonly also used in the electronics industry. Examples include alloys composed of Sn, Ag, Cu in different compositions (so-called SAC solder alloys), and Au. For example, an alloy composed of 93.6% Sn, 4.7% Ag, and 1.7% Cu has a melting point of 217°C, and a metal alloy composed of 80% Au, and 20% Sn has a melting point of 280°C. For instance, for packaging of power LED, solder paste SAC305 composed of 96.5% Sn, 3.0% Ag, and 0.5% Cu is used. The previously mentioned materials are only a few examples. The industry uses at least 40 different solder compositions and the list of possible combinations is extensive. While figure 1 shows similar thickness for the two solder layers 3 and 4, it is clear that the thickness of the respective layers can be adjusted to tune the melting point and composition of the mixed phase that is formed after reflow. For example, if a rather high melting point should be achieved, the thickness of the at least another layer of solder 4 should be higher than that of the outermost layer of solder 3. The composition of the final solder can be tuned to achieve a desired melting point or physical property by selecting a composition of the first solder and thickness and a composition of the second solder and thickness.

This new type of self-assembly process allows to use a solder stack to form reliable and resilient electrical or mechanical connections, either single or multiple, between the components 1 and the substrate 2, the components 1 being for example semiconductor chips, dies, LED for solid state lighting, RFID-tags, and/or even mechanical parts.

In an advantageous embodiment to enable assembly in large volumes, the substrate 2 has multiple receptor sites mounted on a conveyor belt. An example is shown in figure 2, with a substrate 2 on a conveyor belt 7 moving from left to right through the respective temperature regions. Displayed are four zones, marked by the small curved double lines dividing the conveyor belt 7 and the substrate 2, respectively, in different regions. The first region on the left is used to melt the outermost layer of solder 3 which drives the self-assembly of the components 1 into a stable and self-aligned position in the next region. This step takes place in the first fluid 6, while the outermost layer of solder 3 is molten before entering the first fluid 6. When the components 1 are self-aligned and fixed at their positions, they enter a third region where they can be inspected for example, either manually or by an automatic process using image processing, the latter being the process of choice since the solder stack is repeatedly arranged over an extended surface area and comprises a large number of receptor sites. The next step shown in a fourth region on the right side of figure 2 corresponds to the high temperature reflow step of the entire solder stack to form an interconnecting alloy with sufficiently high melting point to ensure operation in real world electronic applications.

Instead of mounting the substrate 2 on a conveyor belt 7, the substrate 2 can also be mounted on a web; it is also possible that the web itself forms the substrate 2.

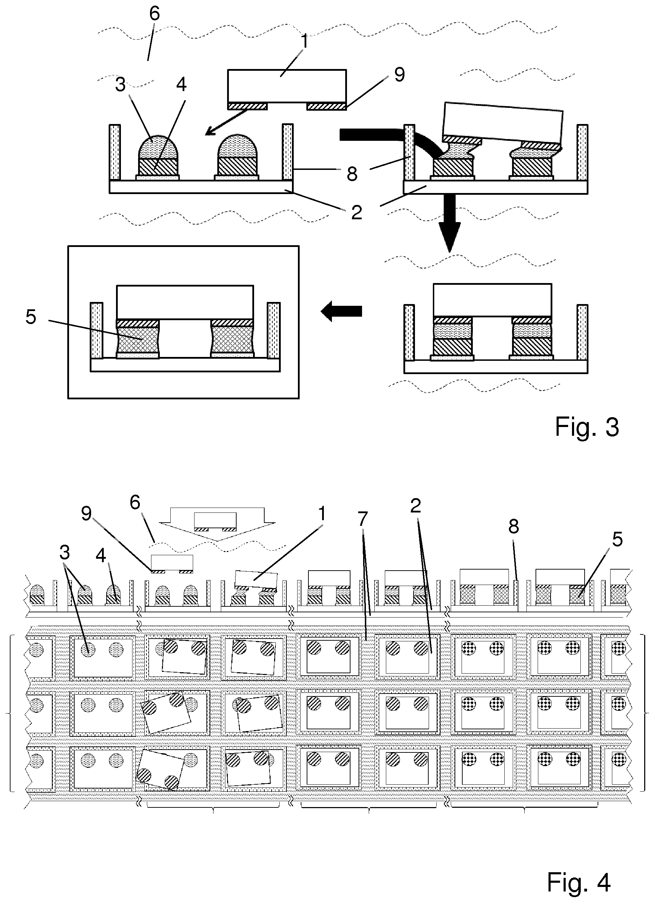

Referring now to figure 3, in another advantageous embodiment pedestals 8 are used on the substrate 2 in combination with the solder stack to define docking sites to assemble components 1 onto the surface of the substrate 2 with unique angular rotation and/or contact pad registration. Instead of having only one metal contact 9 like the components 1 shown in figure 1, the components 1 displayed in figure 3 have two metal contacts 9, they therefore have to be aligned with correct orientation on the substrate to ensure their function. To achieve correct orientation and electrical connections of the components 1 as an integral part of the self-assembly process using the solder stacks, pedestals 8 are used which divide the substrate into different regions. This embodiment is in particular advantageous when used together with a conveyor belt 7 as shown in figure 4, or webs. In figure 4, the components 1 are displayed in a transparent manner to make to contact pads on the surface of the substrate 2 and on the components 1 visible. The process easily can be extended to more than two connections.

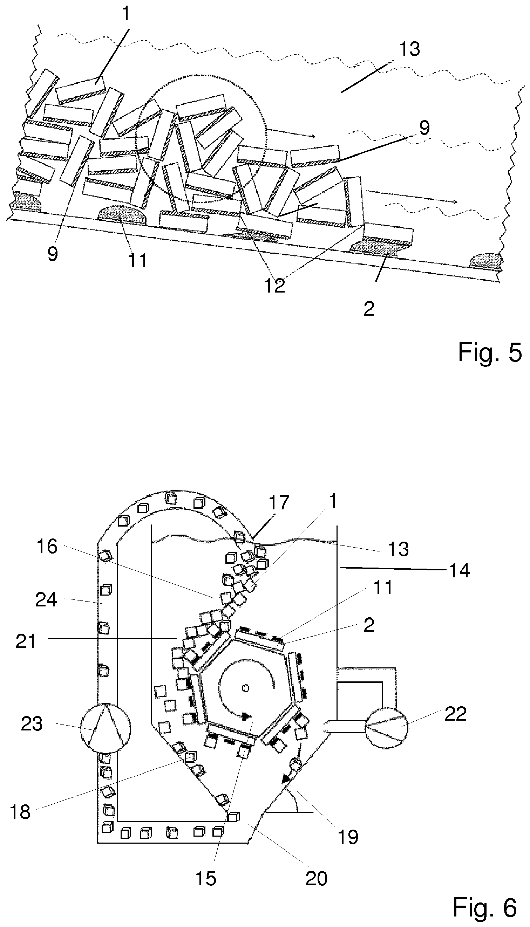

The invention itself is related to avoiding shear forces as they occur in self-assembly methods according to the state of the art as described for example in US 5,545,291 and US 7,774,929 and mentioned in detail in the beginning. Scaling the self-assembly mechanism to larger areas, however, is more challenging in the case where protruding objects have to be assembled, since the protruding objects are exposed to additional shear forces. In particular protruding objects interfere with the component delivery mechanism which has been done using a slurry of self-assembly components that slides a long the surface to populate receptor sites. Assembly yields exceeding 99% using the mechanism of surface tension driven self-assembly as described in US 7,774,929 has only been achieved using a closed barrel design where the self-assembly substrate is attached inside the barrel and where the self-assembly surface points to the centre of the barrel, and where the inside of the barrel is filled with a suspension of self-assembly components. The closed barrel design forms a tilted plane where excess self-assembly components slide down to assemble on empty receptors. However, in case where the self-assembled objects are raised features which are not flush with the intermediate surrounding surface the sliding motion of the aggregated component slurry causes a lateral shear force as shown for example in figure 5. Here, a large number of components 1 with metal contacts 9 is shown in a liquid environment 10 as they slide along an inclined surface of a substrate 2. On the substrate 2, receptor sites 11 are arranged. Due to the large number of components, on some of the components already adhered to the selective adhesive element, massive shear forces are exerted as demonstrated at shear points 12, resulting in a lateral shift of already assembled components 1 which might in the worst case lead to removal of those components 1 or in an alignment which is not correct.

This difficulty can be overcome applying a fluidic self-assembly method of a plurality of components 1 onto receptor sites 11 on the surface of a substrate 2, where each receptor site 11 is formed of a selective adhesive which adheres to at least a part of the components 1 resulting in the capture, self-alignment and/or attachment of the components 1 at the receptor sites 11. An apparatus for performing this method will be described further below referring to figure 6 which also serves to exemplify the method steps. The selective adhesive element might be a simple solder junction, a simple hydrophobic adhesive or also a solder stack, to list only a few examples. In a first step in this method the substrate 2 with the receptor site 11 is transported in an essentially upright position at a predetermined speed into a delivery zone, the zone comprising a fluid 13. For example, currently the speed may be chosen in a range between 1 cm/min and 100cm/min, but eventually larger speed can be applied as technology advances. The components 1 are dispensed into the fluid 13 by a dispensing unit located above the delivery zone, resulting in a portion of components 1 getting attached to receptor sites 11 and a remaining portion of components 1 forming excess components not attached to receptor sites 11. "Essentially upright" means that in the delivery zone the substrate and the receptor site 11 on it are aligned to a horizontal plane in a way that components 1 getting adhered will not slide down due to gravity. Apart form a horizontal orientation the expression "essentially upright" therefore also includes planes with an inclination angle where this condition is fulfilled. The inclination angle depends on the liquid and on the density of the components; it might for example take values in a range up to 55° for slow moving substrates and up to 75° in cases where the substrate velocity is increased.

In the next step the substrate 2 is transported out of the delivery zone and rotated into a position where the receptor sites 11 take an essentially upside-down position, thereby forcing excess components stuck at the surface of the substrate 2 to drop off it and to sink to a lower region. Here again, the expression "essentially upside-down" includes a large variety of angles of inclination apart from the horizontal plane at which excess components drop off the substrate 2. The inclination angle might be - 45° for example.

Excess components are collected at at least one collecting point at the bottom of the lower region and transported back to the dispensing unit through at least one pathway. Then they are reused.

Speed and optionally the angle of inclination are adjusted dependent on the properties of the fluid 13 and of the components 1 to minimize the force exerted by excess components onto already assembled components 1.

To support removing excess components remaining on the substrate after rotating it into the essentially upside-down position, the substrate might be vibrated or a liquid jet might be directed onto the surface of the substrate 2, using the fluid 13. Vibration and jet can also be applied together.

Figure 6 shows the basic concept of an apparatus which can be used for performing the method described above, i.e. for self-assembly of components 1 onto receptor sites 11 of the surface of a substrate 2, where each receptor site 11 is formed of a selective adhesive element which adheres to at least a part of the components 1 resulting in the capture, self-assembly, self-alignment and/or attachment of the components 1 at the receptor sites 11. The apparatus shown in figure 1 comprises a basin 14 containing a fluid 13. The apparatus further comprises first transporting means for transporting the substrate 2 with the receptor sites 11 in an essential upright position at a predetermined speed and/or angle of inclination into and out of a delivery zone 16 in the fluid 13. Above the delivery zone 16 a dispensing unit 17 is located which is used for dispensing components 1 into the fluid 13 and onto the substrate 2. The apparatus further comprises rotating means for rotating the substrate 2 into a position where the receptor sites 11 take an essentially upside-down position. The apparatus also comprises collecting means for collecting excess components 18 not attached to receptor sites 11 at the bottom of the basin 14, and second transporting means for returning excess components 18 to the dispensing unit 17.

The first transporting means comprise a uniform prism shaped rod 15 which is composed of several flat elements resulting in a rod 15 with a polygonal cross section. In the example shown in figure 1, the cross section corresponds to a hexagon, but shapes of other regular polygons or even of a circular cross section are also applicable. However, larger flat areas have the advantage that predetermined speed and/or optional an inclination angle can be kept over a longer distance and/or time respectively. The rotating means form an integrated part of the first transporting means; the rod 15 is rotated about its axis of symmetry. Components 1 are dropped from above by the dispensing unit 17 into the basin 14. Due to the rotation of rod 15, a flow is induced in the fluid 13 resulting in a drift of the components 1 after having entered basin 14. The dispensing unit 8 can be located above the surface of fluid 13, but its outlet can also be located below the surface level of fluid 13.

Located at the bottom of the basin 14, the connecting means include at least a funnel 19 for connecting the excess components 18, the exit 10 of funnel 19 being connected to the second transporting means.

As can be seen in figure 6, the components 1 are getting attached to receptor sites 11 when in a region 21. There, the drift of components 1 which is directed in the figure to the left and downwards corresponds to the angle of inclination of the substrate 2 currently in that region 21 and to its current tangential velocity in region 21. The rotating speed of the rod 15 preferably is adapted to minimize the shear force that is exerted by excess components 18 - which are for example chips or dies - onto already assembled components 1.

Shear forces on already self-assembled components 2 that arise above the surface can be almost completely eliminated momentarily by using this mechanism. When the rod 15 is rotating further, excess components 18 stuck to the surface are dropping down from it due to the gravitational force when the substrate takes a position with receptor sites 11 in an essentially upside-down position. Essentially upside-down and essentially upside in this relation does not mean that the substrate has to be orientated strictly in a horizontal manner, but also includes inclination angles up to at least 45°.

Excess components 18 which have not been attached to receptor sites 11, for example due to the fact that at the position where those components reached the substrate 2 already a component 1 had been attached, or due to a wrong orientation of the component at the point when it reached the surface of the substrate 2, are collected at the bottom of the basin 14 using the funnel 19. The direction of sedimentation and capture of the excess components 18 is achieved using inclined planes which are forming the walls of the funnel 19. Other collecting means comprising inclined planes not in the shape of a funnel, but for example in the form of a "V" or else, might also be used. The sedimentation is driven by gravity and not liquid motion or drag forces. In other words there is no need for liquid flow, which would result in excessive flow rates in the confined collection points. Nevertheless, this collection process is limited to components 1 that have a higher density than the surrounding liquid. The inclination angle of the funnel 19 or the inclined planes might and should be adapted according to the density or mass of the components 1 in relation to the density of liquid 13. When for example semi conductor chips composed of silicon with a density of 2.33g/cm³ and of GaN, having a density of 6.15g/cm³ the angle of inclination should exceed 30° to avoid undesired non-specific adhesion of objects at the inclined surfaces.

In such a case there would be a need for additional means to remove components 1 from the inclined surfaces where they got stuck, for example by using a liquid jet. Otherwise the components would no longer participate in the self-assembly process. For example, for the aforementioned components of silicon and gallium nitride with side lengths in the range of 0.1 mm to 5 mm, an angle of 60° performs very well. Using clean and polished glass as material for the surface of the inclined planes of the funnel 11, almost al components are collected.

By using a continuous component delivery mechanism from the top shear forces on already self-assembled components that arise above the surface can be eliminated. Component dispensing is based on gravity-based sedimentation, both sliding motion and shear forces can be adjusted to be essentially zero by adjusting the velocity of the forward motion of the substrate and optionally adjusting the inclination angle.

Basically, the upside-down removal of excess components 18 uses gravity, but can be assisted with or without liquid jet, the latter for example produced by a pump 22. Successive passes underneath of the dispensing elements in combination with intermediate upside-down orientation of the self-assembly substrate increases the self-assembly yield which is measured by the number of receptor sites 11 that have captured a component 1. Particular in cases where the pitch of the assembly is only slightly larger than the component size several passes are required to achieve yields approaching 100%. The reason for the appearance of defects is that a fraction of the receptors get obstructed with components 1 that are not oriented correctly for the self-assembly to take place. Affected receptors and regions with non-specific adhesion get cleaned as the effected substrate is rotated to the essentially upside-down position. Successive passes complete the self-assembly.

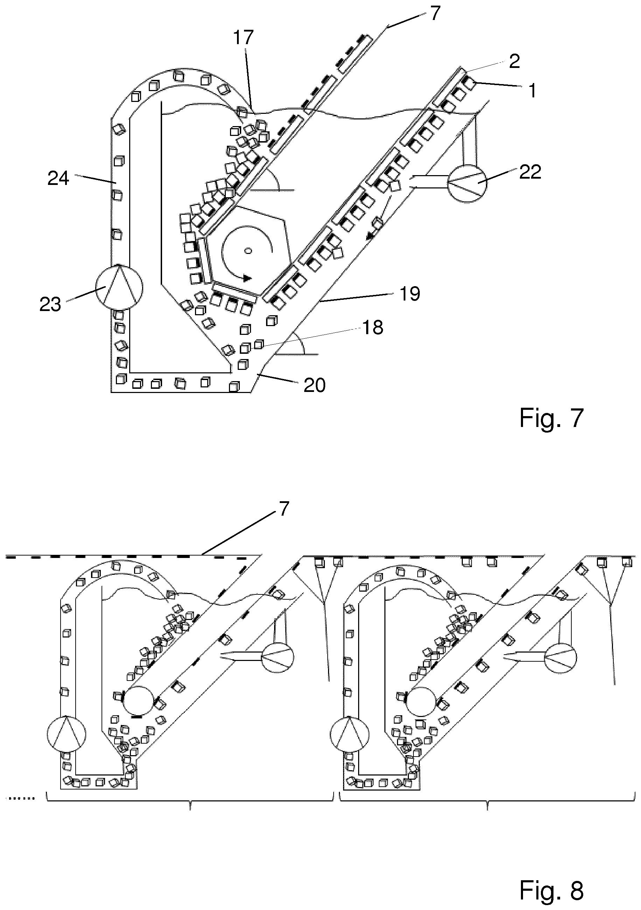

Figure 7 shows a similar apparatus as in figure 6, the difference being mainly that instead of rod 15, a conveyor belt 7 is used. This makes it possible to keep the angle of inclination for the substrate 2 over a longer distance, i.e. the substrate can be kept longer in the essentially upright or essentially upside-down position which makes attachment and removal more efficient and controllable. Instead of a conveyor belt 7, also a web could be used.

The rotating means are preferably an integrated part of the first transporting means and located at the reversal point for the movement of the conveyor belt or of the web, respectively. For the second transporting means, a pump 23 can be used which is shown here in a pathway 24 connecting the exit of the funnel 20 with the dispensing unit 17. The pump 23 is used to pump excess components 18 collected in the funnel 19 from the exit of the funnel 20 to the dispensing unit 17.

Figure 8 shows a combination of two of such apparatus, which are connected only by the conveyor belt 7. Such an arrangement might for example be used to assemble different components on the substrate 2. The substrate might comprise different receptor sites, a portion of them being selectively adhesive only for components in the left apparatus and the other portion being selectively adhesive only for components in the apparatus on the right side of figure 8. However, the arrangement of fig. 8 might also be used to improve efficiency by using the same type of components in both apparatus. Again, instead of a conveyor belt 7 a web can be used.

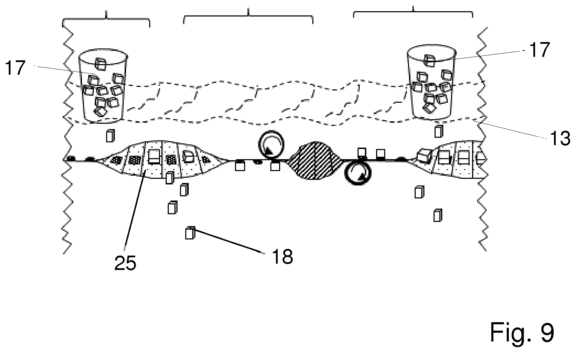

While usually conveyor belts 7 are rotated and reversed in their direction of motion around an axis perpendicular to the direction of transport, and while this also is standard for webs, the latter can also be rotated around a rotation axis which is parallel to the direction of transport as shown in figure 9.

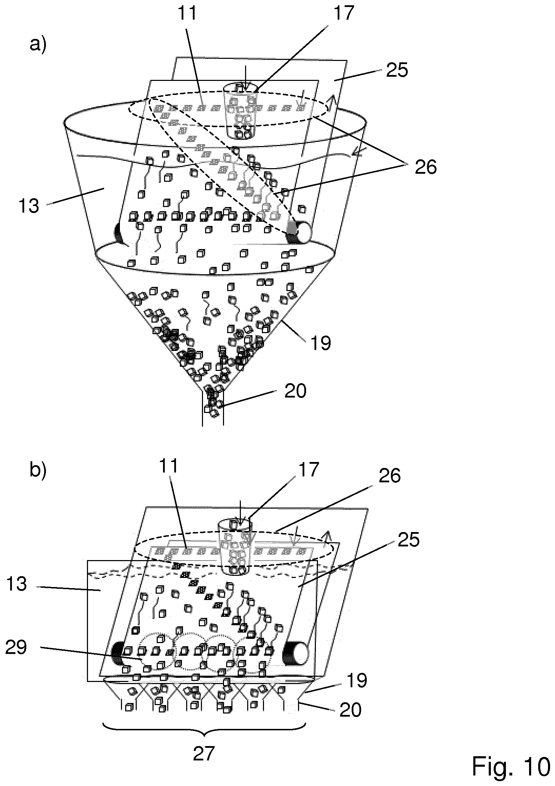

When using conveyor belts or webs, these can be designed rather wide so that it becomes possible to repeat several receptor sites 11 in a direction not parallel to the direction of transport, in particular in a direction essentially perpendicular to this direction. The receptor sites 11 are repeated in rows of reception regions 26 on the substrate, as shown in figure 10a) and 10b). The use of a single funnel 19 as shown in figure 10a becomes impractical for increasingly wide webs. It leads to large volumes, which limit speed in terms of recycling the components, and it also increases the time needed for reloading the apparatus and successive runs. In case of solder directed self-assembly which requires a heated fluid 13 it further requires more time to heat the self-assembly solution. Finally, recycling of the components from a lower sedimentation point using pumps becomes also increasingly difficult since those pumps need more power.

In an advantageous embodiment shown in figure 10b) therefore at the bottom of the basin 14 several collecting regions are defined, the number of collecting regions preferably corresponding to the number of receiving regions 29 in a row to separately collect excess components 18. Preferably each collection region is connected to a separate funnel, the widths and throughput of the assembly apparatus is increased repeating this design to accommodate increasingly wide webs. Exactly this situation is shown in figure 10b), here a linear funnel array 27 is integrated in the apparatus below the turning point at the web 25 or at the reversal point of a tilted conveyor belt. The depicted collection and re-circulation module shows six parallel funnels. The dimensions of the collection block are reduced; the thickness behaves roughly inversely linear to the number of funnels in the linear array 27. For example, considering a web 25 with the width of one meter and an array 27 of 10 overlapping funnels will reduce the diameter and depth of the single funnel 19 by roughly a factor 10, the overall funnel volume will be reduced by a factor of 100. It should be noted, however, that this is only one example and larger or smaller numbers of funnels or similar objects with the same collection function could be used to collect the self-assembly objects, in particular dependent on the width of the web or conveyor belt. It should also be noted, that the Z-shaped receptor pattern is only an example which is kept simple for clarity. For example in solid state lighting applications the preferred receptor pattern is a regular array to distribute LED light sources over increasingly large webs or substrates at a desired pitch leading to an electrically interconnected pattern where the substrate provides the electrical connections to the LEDs.

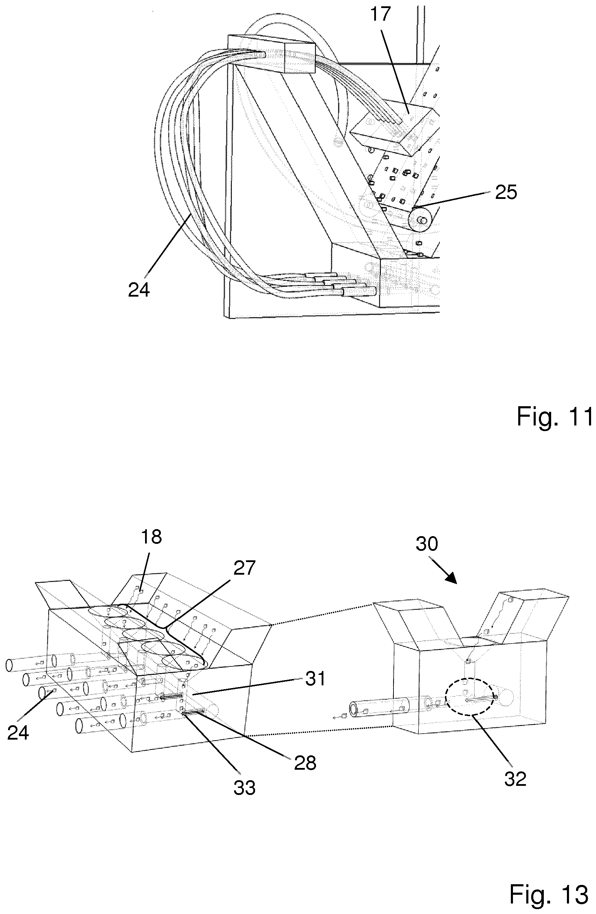

Not only is it possible to use a linear array of collecting points, but this concept can be extended to the dispensing unit 17 as well in that it comprises several inlet openings, the number of inlet openings preferably corresponding to the number of collecting points where each inlet opening is connected by a separate pathway 24 to at least one collecting point. This particular embodiment is shown in figure 11. The array of collection points is connected with several parallel channels to transport the self-assembly components upwards before they are introduced at the surface of the self-assembly substrate again. While it is possible to keep the order of collecting points to be equal to the order of inlet openings, the order might also be changed if the apparatus itself has a somewhat tilted orientation leading to the situation that for example at the leftmost collecting point more excess components 18 are collected then at the rightmost collecting point, considered from the direction of transport. In that case, the pathway 24 from the leftmost collecting point could be connected to the rightmost inlet opening of the dispensing unit 17.

To reuse excess components 18 they have to be transported somehow to the dispensing unit 17 using a pumping mechanism. However, components might get damaged as they pass through conventional mechanical pumps that use moving mechanical parts like blades, pistons or membranes. On the other hand excess components 18 continuously have to be transported up to the dispensing unit 17 to be brought into close proximity to the substrate 2.

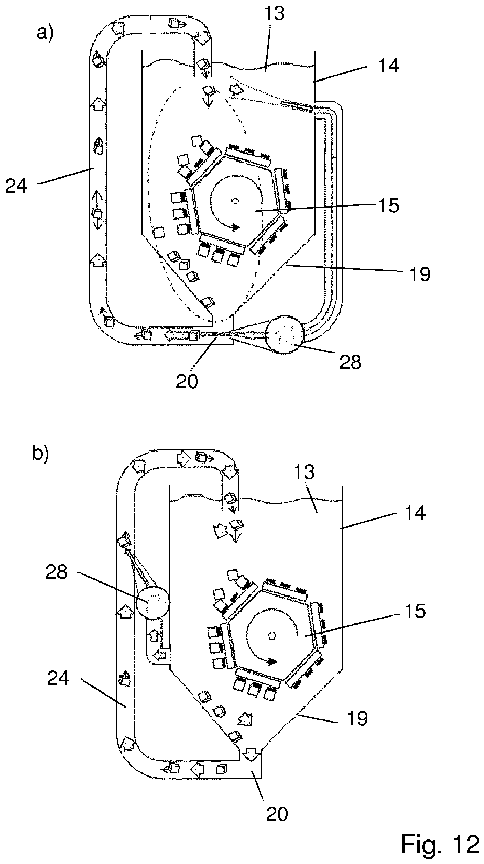

Turning now to figure 12, a detail of the apparatus shown in figure 6 is depicted, focussing on the transport mechanism, i.e. the second transporting means for returning excess components 18 back to the dispensing unit 17. In the preferred embodiment shown in figures 12 a) and b) the pumping means as being part of the second transporting means include at least one jet pump 28 for generating a jet of liquid. Excess components 18 are collected by the funnel 19 at its exit 20 on the basis of gravity. Transport of the self-assembly components 1 to higher altitudes and remote locations including the self-assembly substrate 2 is achieved using a jet pump principle which in figure 12a) includes a three-way terminal junction with a reduced junction on one side, the jet pump 28 preferably being equipped with a Venturi nozzle or an orifice plate. The jet leads to a liquid circulation though the pathways 24 which transport the excess components 18 due to the drag force to remote points. The excess components 18 do not pass though a mechanical pump with moving parts and are not damaged as a result. Figure 12a) shows the preferred embodiment. Clogs at the exit location that form once the system is turned off can be cleared using a valve in pathway 24 that turns off pathway 24 diverting the liquid flow upward at exit 20 which disassembles the clog dispersing the components above the funnel region. In an alternative embodiment, the jet pump 28 is located along the pathway 24 at some higher altitude. However, this alternative has also a disadvantage in that it leads to additional downward liquid flow at exit 20 which might damage the components 1. It is also not effective in removing clogs. Important is that a fluid current produced due to reduced pressure at the exit 20 of the funnel such that excess components 18 are transported away through pathway 24 during steady state operation without having an excessive flow rate at junction points which could damage components 1. The embodiments shown in figures 12a) and 12b) might also be combined with each other, further it might also be advantageous to use another jet pump to direct an upward jet into the funnel region to remove clogs which may occur due to excessive collection of excess components 18.

The concept of using a jet pump 28 might in particular also be combined with the linear funnel array 27, as shown in figure 13. The basic building unit 30 is shown at the bottom right and is repeated to increase the width of the collection unit while maintaining the same cross section In the illustrated design a manifold 31 connects to a linear array of n=5 inverted T-shaped three-way junctions 32. The manifold 31 distributes the incoming pressurized fluid to produce n liquid jets due to the reduced diameter port opening 33 and/or orifice plate. Excess components 18 are collected by the funnel 19 at its exit on the basis of gravity. The particular design minimizes liquid flow in this region. No downward liquid is required and components tumble down on the basis of gravity. A downward liquid flow produces additional shear forces which are prevented. The directed jet transports the excess components 18 away to the left and subsequently through pathways 24 which transport the excess components 18 back to the dispensing unit.

### List of reference numerals

- 1: component
- 2: substrate
- 3: outermost layer of solder
- 4: another layer of solder
- 5: alloy
- 6: first fluid
- 7: conveyor belt
- 8: pedestal
- 9: metal contact
- 10: liquid environment
- 11: receptor site
- 12: shear point
- 13: fluid
- 14: basin
- 15: rod
- 16: delivery zone
- 17: dispensing unit
- 18: excess component
- 19: funnel
- 20: exit of the funnel
- 21: region of assembly
- 22: pump
- 23: pump
- 24: pathway
- 25: web
- 26: receptor regions
- 27: funnel array
- 28: jet pump
- 29: receiving regions
- 30: basic building unit
- 31: manifold
- 32: three-way junction
- 33: port opening

## Claims

1. Method of fluidic self-assembly of a plurality of components (1) onto receptor sites (11) on the surface of a substrate (2), where each receptor site (11) is formed of a selective adhesive which adheres to at least a part of the components (1) resulting in the capture, self-alignment, and/or attachment of the components (1) at the receptor sites (11), comprising the steps of:
a) transporting the substrate (2) with the receptor sites at a predetermined speed into a delivery zone (16) comprising a fluid (13), with components (1) being dispensed into the fluid (13) by a dispensing unit (17) located above the delivery zone (16), resulting in a portion of components (1) getting attached to receptor sites (11) and a remaining portion of components forming excess components (18) not attached to receptor sites (11), whereby the substrate (2) with the receptor sites is in a position such that the substrate and the receptor sites are aligned with the horizontal plane or with a plane having an angle of inclination against the horizontal plane such that the components getting attached to receptor sites do not slide down due to gravity,
b) transporting the substrate (2) out of the delivery zone (16) and inclining it into a position where the receptor sites (11) take a position at which excess components (18) stuck at the surface of the substrate (2) drop off the substrate (2) and sink to a lower region,
c) collecting the excess components (18) at at least one collecting point at the bottom of the lower region,
d) transporting the excess components (18) through at least one pathway (24) back to the dispensing unit (17) where they are reused.

2. Method according to claim 1, **characterized in that** in step a) speed and optionally an angle of inclination are adjusted dependent on the properties of the fluid (13) and of the components (1).

3. Method according to claim 1 or 2, **characterized in that** excess components (18) remaining on the substrate (2), after inclining it into the position at which excess components (18) drop off the substrate (2) are removed by vibrating the substrate (2) and/or directing a liquid jet onto the surface of the substrate (2) using the fluid (13).

4. Method according to one of claims 1 to 3, **characterized in that** in a direction not parallel to the direction of transport in step a), preferably perpendicular to it, several receptor sites (11) are repeated in rows of reception regions (26) on the substrate (2) and that at the bottom of the lower region several collecting points are defined where the excess components (18) are collected separately.

5. Method according to one of claims 1 to 4, **characterized in that** in step d) a liquid jet is directed onto the excess components (18) at the at least one collecting point or in the at least one pathway (24) used for transporting the excess components (18) to the dispensing unit (17), thereby pumping them into the dispensing unit (17) above the substrate (2).

6. Method according to one of claims 1 to 5, **characterized in that** the substrate is mounted on a conveyor belt (7), or mounted on or formed by a web (25).

7. Apparatus for fluidic self-assembly of a plurality of components (1) onto receptor sites (11) of the surface of a substrate (2), where each receptor site (11) is formed of a selective adhesive element which adheres to at least a part of the components (1) resulting in the capture, self-assembly, self-alignment, and/or attachment of the components (1) at the receptor sites (11), comprising
- a basin (14) containing a fluid (13),
- first transporting means for transporting the substrate (2) at a predetermined speed and/or angle of inclination into and out of a delivery zone (16) in the fluid (13),
- a dispensing unit (17) located above the delivery zone (16) for dispensing components (1) into the fluid (13) and onto the substrate (2), whereby the substrate (2) with the receptor sites is in a position such that the substrate and the receptor sites are aligned with the horizontal plane or with a plane having an angle of inclination against the horizontal plane such that the components getting attached to receptor sites do not slide down due to gravity,
- rotating means for inclining the substrate (2) into an essentially upside-down position where the receptor sites (11) take a position at which excess components drop off the substrate (2),
- collecting means for collecting excess components (18) not attached to receptor sites (11) at the bottom of the basin (14), and
- second transporting means for returning excess components (18) to the dispensing unit (17).

8. Apparatus according to claim 7, **characterized in that** the first transporting means comprise a conveyor belt (7) or a web (25) where the substrate (2) is mounted on, or that the substrate (2) itself forms a web (25), and that the rotating means are an integrated part of the first transporting means located at a reversal point for the movement of the conveyor belt (7) or of the web (25).

9. Apparatus according to one of claims 7 or 8, **characterized in that** it further comprises removal means for removing excess components (18) stuck at the surface of the substrate (2), the removal means preferably comprising vibrating means for mechanically vibrating the substrate (2) and/or jet directing means for directing a liquid jet onto the substrate (2) after it has been inclined.

10. Apparatus according to one of claims 7 to 9, **characterized in that** the collecting means include at least a funnel (19) at the bottom of the basin (14) for collecting the excess components (18), the exit (20) of the funnel (19) being connected to the second transporting means.

11. Apparatus according to claim 10, **characterized in that** the second transporting means are comprising a pathway (24) leading from the exit (20) of the funnel (19) to the dispensing unit (17), and are further comprising pumping means for pumping excess components (18) collected in the funnel (19) from the exit (20) of the funnel (19) to the dispensing unit (17).

12. Apparatus according to claim 11, **characterized in that** the pumping means include at least one jet pump (28) for generating a jet of liquid, the jet pump (28) being preferably equipped with a Venturi nozzle or an orifice plate.

13. Apparatus according to claim 12, **characterized in that** the at least one jet pump (28) is connected to the pathway (24), or to the pathway (24) and the exit (20) of the funnel (19), by a three-way terminal junction.

14. Apparatus according to one of claims 7 to 13, **characterized in that** in a direction not parallel to the direction of transport of the first transporting means, preferably perpendicular to it, several receptor sites (11) are aligned in rows of reception regions (26) on the substrate (2) and that at the bottom of the basin (14) the collecting means comprise several collecting points, defined, the number of collecting points preferably corresponding to a number of receiving regions (29) in a row, to separately collect excess components (18), where each collection point is connected to a separate funnel, preferably connected to a linear array (27) of funnels.

15. Apparatus according to claim 14, **characterized in that** the dispensing unit (17) comprises several inlet openings, the number of inlet openings preferably corresponding to the number of collecting points, where each inlet opening is connected by a separate pathway (24) to at least one collecting point.

16. Apparatus according to one of claims 7 to 15, **characterized in that** the selective adhesive element is formed of solder or of a solder stack, and that the fluid (13) in the basin (14) is heated above the melting point of the solder or an outermost layer (3) of the solder stack.

## Patentansprüche

1. Verfahren zur fluidischen Selbstmontage mehrerer Komponenten (1) auf Rezeptorstellen (11) auf der Oberfläche eines Substrats (2), wobei jede Rezeptorstelle (11) aus einem selektiven Klebstoff gebildet ist, der an wenigstens einem Teil der Komponenten (1) klebt, was zum Erfassen, Selbstausrichten und/oder Anbringen der Komponenten (1) an den Rezeptorstellen (11) führt, das die folgenden Schritte beinhaltet:
a) Transportieren des Substrats (2) mit den Rezeptorstellen mit einer vorbestimmten Geschwindigkeit in eine Lieferzone (16), die ein Fluid (13) umfasst, wobei Komponenten (1) von einer über der Lieferzone (16) befindlichen Ausgabeeinheit (17) in das Fluid (13) ausgegeben wird, was zur Folge hat, dass ein Teil von Komponenten (1) an Rezeptorstellen (11) angelagert wird und ein restlicher Teil von Komponenten, die überschüssige Komponenten (18) bilden, nicht an Rezeptorstellen (11) angelagert wird, so dass das Substrat (2) mit den Rezeptorstellen in einer solchen Position ist, dass das Substrat und die Rezeptorstellen mit der horizontalen Ebene oder mit einer Ebene mit einem Neigungswinkel gegenüber der horizontalen Ebene ausgerichtet werden, so dass die Komponenten, die an Rezeptorstellen angelagert werden, nicht schwerkraftbedingt abrutschen,
b) Transportieren des Substrats (2) aus der Lieferzone (16) und neigen desselben in eine Position, in der die Rezeptorstellen (11) eine Position annehmen, in der überschüssige Komponenten (18), die an der Oberfläche des Substrats (2) kleben, vom Substrat (2) abfallen und in eine tiefere Region absinken,
c) Auffangen der überschüssigen Komponenten (18) an wenigstens einem Auffangpunkt am Boden der tieferen Region,
d) Transportieren der überschüssigen Komponenten (18) durch wenigstens einen Pfad (24) zurück zur Ausgabeeinheit (17), wo sie wiederverwendet werden.

2. Verfahren nach Anspruch 1, **dadurch gekennzeichnet, dass** in Schritt a) die Geschwindigkeit und optional ein Neigungswinkel je nach den Eigenschaften des Fluids (13) und der Komponenten (1) justiert werden.

3. Verfahren nach Anspruch 1 oder 2, **dadurch gekennzeichnet, dass** überschüssige Komponenten (18), die auf dem Substrat (2) verbleiben, nachdem es in die Position geneigt wurde, in der überschüssige Komponenten (18) vom Substrat (2) abfallen, durch Schütteln des Substrats (2) und/oder Leiten eines Flüssigkeitsstrahls auf die Oberfläche des Substrats (2) mit dem Fluid (13) entfernt werden.

4. Verfahren nach einem der Ansprüche 1 bis 3, **dadurch gekennzeichnet, dass** in einer Richtung nicht parallel zur Transportrichtung in Schritt a), vorzugsweise lotrecht dazu, mehrere Rezeptorstellen (11) in Reihen von Aufnahmeregionen (26) auf dem Substrat (2) wiederholt werden, und dass am Boden der unteren Region mehrere Auffangpunkte definiert sind, wo die überschüssigen Komponenten (18) separat aufgefangen werden.

5. Verfahren nach einem der Ansprüche 1 bis 4, **dadurch gekennzeichnet, dass** in Schritt d) ein Flüssigkeitsstrahl auf die überschüssigen Komponenten (18) an dem wenigstens einen Auffangpunkt oder in dem wenigstens einen Pfad (24) gerichtet wird, der zum Transportieren der überschüssigen Komponenten (18) zur Ausgabeeinheit (17) benutzt wird, um sie dadurch in die Ausgabeeinheit (17) über dem Substrat (2) zu pumpen.

6. Verfahren nach einem der Ansprüche 1 bis 5, **dadurch gekennzeichnet, dass** das Substrat auf einem Förderband (7) montiert oder auf einer Bahn (25) montiert oder davon gebildet wird.

7. Vorrichtung zum fluidischen Selbstmontieren mehrerer Komponenten (1) an Rezeptorstellen (11) der Oberfläche eines Substrats (2), wobei jede Rezeptorstelle (11) aus einem selektiven Klebstoffelement gebildet ist, das an wenigstens einem Teil der Komponenten (1) klebt, was zum Erfassen, Selbstmontieren, Selbstausrichten und/oder Anlagern der Komponenten (1) an den Rezeptorstellen (11) führt, die Folgendes umfasst:
- ein ein Fluid (13) enthaltendes Becken (14),
- erste Transportmittel zum Transportieren des Substrats (2) mit einer/m vorbestimmten Geschwindigkeit und/oder Neigungswinkel in eine und aus einer Lieferzone (16) in dem Fluid (13),
- eine über der Lieferzone (16) befindliche Ausgabeeinheit (17) zum Ausgeben von Komponenten (1) in das Fluid (13) und auf das Substrat (2), so dass das Substrat (2) mit den Rezeptorstellen in einer solchen Position ist, dass das Substrat und die Rezeptorstellen mit der horizontalen Ebene oder mit einer Ebene mit einem Neigungswinkel gegenüber der horizontalen Ebene ausgerichtet werden, so dass die Komponenten, die an Rezeptorstellen angelagert werden, nicht schwerkraftbedingt abrutschen, und
- Drehmittel zum Neigen des Substrats (2) in eine im Wesentlichen umgekehrte Position, in der die Rezeptorstellen (11) eine Position annehmen, in der überschüssige Komponenten vom Substrat (2) abfallen,
- Auffangmittel zum Auffangen überschüssiger Komponenten (18), die nicht an Rezeptorstellen (11) angelagert sind, am Boden des Beckens (14), und
- zweite Transportmittel zum Zurückführen überschüssiger Komponenten (18) zur Ausgabeeinheit (17).

8. Vorrichtung nach Anspruch 7, **dadurch gekennzeichnet, dass** die ersten Transportmittel ein Förderband (7) oder eine Bahn (25) umfassen, auf der das Substrat (2) montiert ist, oder das Substrat (2) selbst eine Bahn (25) bildet, und die Drehmittel ein integrierter Bestandteil der ersten Transportmittel sind, befindlich an einem Umkehrpunkt für die Bewegung des Förderbands (7) oder der Bahn (25).

9. Vorrichtung nach Anspruch 7 oder 8, **dadurch gekennzeichnet, dass** sie ferner Entfernungsmittel zum Entfernen überschüssiger Komponenten (18) umfasst, die an der Oberfläche des Substrats (2) kleben, wobei die Entfernungsmittel vorzugsweise Vibrationsmittel zum mechanischen Inschwingungversetzen des Substrats (2) und/oder Strahlleitmittel zum Leiten eines Flüssigkeitsstrahls auf das Substrat (2) umfassen, nachdem es geneigt wurde.

10. Vorrichtung nach einem der Ansprüche 7 bis 9, **dadurch gekennzeichnet, dass** die Auffangmittel wenigstens einen Trichter (19) am Boden des Beckens (14) zum Auffangen der überschüssigen Komponenten (18) aufweisen, wobei der Ausgang (20) des Trichters (19) mit den zweiten Transportmitteln verbunden ist.

11. Vorrichtung nach Anspruch 10, **dadurch gekennzeichnet, dass** die zweiten Transportmittel einen vom Ausgang (20) des Trichters (19) zur Ausgabeeinheit (17) führenden Pfad (24) und ferner Pumpmittel zum Pumpen im Trichter (19) aufgefangener überschüssiger Komponenten (18) vom Ausgang (20) des Trichters (19) zur Ausgabeeinheit (17) umfassen.

12. Vorrichtung nach Anspruch 11, **dadurch gekennzeichnet, dass** die Pumpmittel wenigstens eine Strahlpumpe (28) zum Erzeugen eines Flüssigkeitsstrahls beinhalten, wobei die Strahlpumpe (28) vorzugsweise mit einer Venturi-Düse oder einer Lochplatte ausgestattet ist.

13. Vorrichtung nach Anspruch 12, **dadurch gekennzeichnet, dass** die wenigstens eine Strahlpumpe (28) mit dem Pfad (24), oder mit dem Pfad (24) und dem Ausgang (20) des Trichters (19), über einen Dreiweg-Anschlussübergang verbunden ist.

14. Vorrichtung nach einem der Ansprüche 7 bis 13, **dadurch gekennzeichnet, dass** in einer Richtung nicht parallel zur Transportrichtung der ersten Transportmittel, vorzugsweise lotrecht dazu, mehrere Rezeptorstellen (11) in Reihen von Aufnahmeregionen (26) auf dem Substrat (2) ausgerichtet sind und dass die Auffangmittel am Boden des Beckens (14) mehrere Auffangpunkte umfassen, wobei die Anzahl von Auffangpunkten vorzugsweise einer Anzahl von Aufnahmeregionen (29) in einer Reihe entspricht, um überschüssige Komponenten (18) separat aufzufangen, wobei jeder Auffangpunkt mit einem separaten Trichter, vorzugsweise mit einer linearen Anordnung (27) von Trichtern verbunden ist.

15. Vorrichtung nach Anspruch 14, **dadurch gekennzeichnet, dass** die Ausgabeeinheit (17) mehrere Einlassöffnungen umfasst, wobei die Anzahl von Einlassöffnungen vorzugsweise der Anzahl von Auffangpunkten entspricht, wobei jede Einlassöffnung durch einen separaten Pfad (24) mit wenigstens einem Auffangpunkt verbunden ist.

16. Vorrichtung nach einem der Ansprüche 7 bis 15, **dadurch gekennzeichnet, dass** das gewählte Klebstoffelement aus Lot oder einem Lotstapel gebildet ist, und dass das Fluid (13) im Becken (14) über den Schmelzpunkt des Lots oder einer äußersten Schicht (3) des Lotstapels hinaus erhitzt wird.

## Revendications

1. Procédé d'auto-assemblage à l'aide d'un fluide d'une pluralité de composants (1) sur des sites récepteurs (11) sur la surface d'un substrat (2), dans lequel chaque site récepteur (11) est formé d'un adhésif sélectif qui colle sur au moins une partie des composants (1) entraînant la capture, l'auto-alignement et/ou la fixation des composants (1) au niveau des sites récepteurs (11), comprenant les étapes de :
a) transport du substrat (2) avec les sites récepteurs à une vitesse prédéterminée jusque dans une zone de livraison (16) comprenant un fluide (13), les composants (1) étant distribués à l'intérieur du fluide (13) par une unité de distribution (17) située au-dessus de la zone de livraison (16), résultant en la fixation d'une partie des composants (1) à des sites récepteurs (11) et la non-fixation d'une partie restante de composants constituant des composants en surplus (18) à des sites récepteurs (11), moyennant quoi le substrat (2) avec les sites récepteurs se trouve à une position à laquelle le substrat et les sites récepteurs sont alignés avec le plan horizontal ou avec un plan ayant un angle d'inclinaison par rapport au plan horizontal faisant que les composants se fixant aux sites récepteurs ne glissent pas vers le bas sous l'effet de la gravité,
b) transport du substrat (2) hors de la zone de livraison (16) et l'inclinaison de celui-ci dans une position à laquelle les sites récepteurs (11) adoptent une position à laquelle les composants en surplus (18) collés à la surface du substrat (2) tombent du substrat (2) et s'enfoncent jusqu'à une région inférieure,
c) collecte des composants en surplus (18) au niveau d'au moins un point de collecte au fond de la région inférieure,
d) transport des composants en surplus (18) le long d'au moins un chemin (24) de retour à l'unité de distribution (17) où ils sont réutilisés.

2. Procédé selon la revendication 1, **caractérisé en ce que** à l'étape a) la vitesse et facultativement un angle d'inclinaison sont ajustés en fonction des propriétés du fluide (13) et des composants (1).

3. Procédé selon la revendication 1 ou 2, caractérisé en ce les composants en surplus (18) restant sur le substrat (2), après l'inclinaison de ce dernier à la position à laquelle les composants en surplus (18) tombent du substrat (2) sont éliminés en faisant vibrer le substrat (2) et/ou en dirigeant un jet de liquide sur la surface du substrat (2) à l'aide du fluide (13).

4. Procédé selon l'une des revendications 1 à 3, **caractérisé en ce que** dans un sens non parallèle au sens de transport à l'étape a),
de préférence perpendiculaire à celui-ci, plusieurs sites récepteurs (11) sont répétés en rangées de régions de réception (26) sur le substrat (2) et **en ce qu'**au fond de la région inférieure plusieurs points de collecte sont définis où les composants en surplus (18) sont collectés séparément.

5. Procédé selon l'une des revendications 1 à 4, **caractérisé en ce que**, à l'étape d), un jet de liquide est dirigé sur les composants en surplus (18) au niveau de l'au moins un point de collecte ou dans l'au moins un chemin (24) utilisé pour le transport des composants en surplus (18) jusqu'à l'unité de distribution (17), les pompant ainsi jusque dans l'unité de distribution (17) au-dessus du substrat (2).

6. Procédé selon l'une des revendications 1 à 5, **caractérisé en ce que** le substrat est monté sur une bande transporteuse (7), ou monté sur ou formé par une bande (25).

7. Appareil d'auto-assemblage à l'aide d'un fluide d'une pluralité de composants (1) sur des sites récepteurs (11) de la surface d'un substrat (2), dans lequel chaque site récepteur (11) est formé d'un élément adhésif sélectif qui colle sur au moins une partie des composants (1) entraînant la capture, l'auto-assemblage, l'auto-alignement et/ou la fixation des composants (1) au niveau des sites récepteurs (11), comprenant :
- un bassin (14) contenant un fluide (13),
- des premiers moyens de transport pour transporter le substrat (2) à une vitesse et/ou un angle d'inclinaison prédéterminé(e) dans une zone de livraison (16) et hors de celle-ci dans le fluide (13),
- une unité de distribution (17) située au-dessus de la zone de livraison (16) pour distribuer des composants (1) dans le fluide (13) et sur le substrat (2), moyennant quoi le substrat (2) avec les sites récepteurs se trouve à une position à laquelle le substrat et les sites récepteurs sont alignés avec le plan horizontal ou avec un plan ayant un angle d'inclinaison par rapport au plan horizontal faisant que les composants se fixant aux sites récepteurs ne glissent pas vers le bas sous l'effet de la gravité,
- des moyens de rotation pour incliner le substrat (2) dans une position essentiellement renversée à laquelle les sites récepteurs (11) adoptent une position à laquelle les composants en surplus tombent du substrat (2),
- des moyens de collecte pour collecter les composants en surplus (18) non fixés à des sites récepteurs (11) au fond du bassin (14), et
- des seconds moyens de transport pour renvoyer les composants en surplus (18) à l'unité de distribution (17).

8. Appareil selon la revendication 7, **caractérisé en ce que** les premiers moyens de transport comprennent une bande transporteuse (7) ou une bande (25) sur laquelle le substrat (2) est monté, ou **en ce que** le substrat (2) lui-même forme une bande (25), et **en ce que** les moyens de rotation font partie intégrante des premiers moyens de transport situés à un point de marche inverse du déplacement de la bande transporteuse (7) ou de la bande (25).

9. Appareil selon l'une des revendications 7 ou 8, **caractérisé en ce qu'**il comprend en outre des moyens d'élimination pour éliminer les composants en surplus (18) collés au niveau de la surface du substrat (2), les moyens d'élimination comprenant de préférence des moyens de vibration pour faire vibrer mécaniquement le substrat (2) et/ou des moyens d'orientation de jet pour diriger un jet de liquide sur le substrat (2) après qu'il a été incliné.

10. Appareil selon l'une des revendications 7 à 9, **caractérisé en ce que** les moyens de collecte comportent au moins un entonnoir (19) au fond du basin (14) pour collecter les composants en surplus (18), la sortie (20) de l'entonnoir (19) étant raccordée aux seconds moyens de transport.

11. Appareil selon la revendication 10, **caractérisé en ce que** les seconds moyens de transport comprennent un chemin (24) conduisant depuis la sortie (20) de l'entonnoir (19) jusqu'à l'unité de distribution (17), et comprennent en outre des moyens de pompage pour pomper les composants en surplus (18) collectés dans l'entonnoir (19) depuis la sortie (20) de l'entonnoir (19) jusqu'à l'unité de distribution (17).

12. Appareil selon la revendication 11, **caractérisé en ce que** les moyens de pompage comportent au moins une pompe à jet (28) pour générer un jet de liquide, la pompe à jet (28) étant de préférence équipée d'une buse à effet Venturi ou d'une plaque perforée.

13. Appareil selon la revendication 12, **caractérisé en ce que** l'au moins une pompe à jet (28) est raccordée au chemin (24), ou au chemin (24) et à la sortie (20) de l'entonnoir (19) par un raccord terminal à trois voies.

14. Appareil selon l'une des revendications 7 à 13, **caractérisé en ce que** dans un sens non parallèle au sens de transport des premiers moyens de transport, de préférence perpendiculaire à celui-ci, plusieurs sites récepteurs (11) sont alignés en rangées de régions de réception (26) sur le substrat (2) et **en ce qu'**au fond du bassin (14) les moyens de collecte comprennent plusieurs points de collecte, le nombre de points de collecte correspondant de préférence au nombre de régions de réception (29) dans une rangée, pour collecter séparément les composants en surplus (18), dans lequel chaque point de collecte est raccordé à un entonnoir séparé, de préférence à un réseau linéaire (27) d'entonnoirs.

15. Appareil selon la revendication 14, **caractérisé en ce que** l'unité de distribution (17) comprend plusieurs ouvertures d'entrée, le nombre d'ouvertures d'entrée correspondant de préférence au nombre de points de collecte, chaque ouverture d'entrée étant raccordée par un chemin séparé (24) à au moins un point de collecte.

16. Appareil selon l'une des revendications 7 à 15, **caractérisé en ce que** l'élément adhésif sélectif est formé de soudure ou d'un empilement de soudure, et **en ce que** le fluide (13) dans le bassin (14) est chauffé au-dessus du point de fusion de la soudure ou d'une couche la plus externe (3) de l'empilement de soudure.
